# EUROPEAN PATENT APPLICATION

(11) **EP 1 659 781 A1**
(43) Date of publication of application: **24.05.2006**
(21) Application number: 05257173.4
(22) Date of filing: 22.11.2005
(51) Int. Cl.: H04N 5/225, G02B 7/02

(54) **Image pickup module and manufacturing method of image pickup module**

(30) Priority: 22.11.2004 JP 2004337978
(71) Applicant: SHARP KABUSHIKI KAISHA, Osaka-shi, Osaka 545-8522 (JP)
(72) Inventor: Hirooka, Shohgo, Kitakatsuragi-gun, Nara 639-0215 (JP)
(74) Representative: Whitlock, Holly Elizabeth Ann

(57) **Abstract**

An image pickup module (1) of the present invention includes a cover (19) in the form of a tube, and a lens holder (17). The cover (19) is fixed (bonded) to a base (11) in a state in which its leg section (19a) is in contact with a surface of the base (11). The lens holder (17) is inserted in an inner surface (19b) of the cover (19), and an outer surface (17b) of the lens holder (17) is fixed (bonded) to the inner surface (19b) of the cover (19) in a state in which the leg section (17a) is in contact with the transparent plate (14), and the outer surface (17b) is in contact with the inner surface of the cover. A lens (18) for guiding a path of incident light to the light receiving section (12a) of the image pickup element (12) is fixed on a predetermined position of the lens holder (17).

## Description

### BACKGROUND OF THE INVENTION

### 1. Field of the Invention

The present invention relates to an image pickup module comprising an image pickup element with a light receiving section, and a lens for focusing incident light on the light receiving section as a module (as a unit), and a method of manufacturing the image pickup module.

### 2. Description of Related Art

Image pickup elements as one type of semiconductors, such as a CCD or a CMOS imager, have been used in various fields. In particular, cell phones with a camera having a camera function in addition to a communication function by installation of an image pickup element have been widely used in practical applications. With a reduction in the size, thickness and weight of products such as a cell phone with a camera and a digital camera, an image pickup module comprising an image pickup element and a lens as a module has been put to practical use.

In a conventional image pickup module, an image pickup element is positioned on a substrate, and the image pickup element is electrically connected to a wiring on the substrate by a bonding wire. Moreover, a lens holder including a focus adjustor in the inner circumference and holding the lens is bonded to the substrate, and the focus adjustor is screw-fitted into the lens holder. By turning the focus adjustor for adjustment, the relative position of the lens with respect to the substrate (that is, the image pickup element) can be changed.

Although the dimensions of the substrate (particularly a dimension in the thickness direction) are within specification values, the substrate is warped, curved or the like due to manufacturing variations. Further, even after bonding the lens holder, such a warp, curve or the like remain. In other words, when positioning the lens, the optical distance from the lens to the image pickup element may not agree with the focus distance of the lens due to the warp or the like of (the surface of) the substrate functioning as a positioning reference. In such a case, it is necessary to adjust the optical distance between the lens and the image pickup element so that it agrees with the focus distance of the lens. Specifically, it was necessary to adjust the optical distance between the lens and the image pickup element according to the focus distance of the lens by turning and adjusting the focus adjustor. Thus, a long time is required to manufacture the image pickup module, and the cost increase is accelerated.

Therefore, there was proposed an image pickup module in which a lens holder holding a lens is connected to a surface of a substrate by using the surface of the substrate where an image pickup element is mounted as a positioning reference, and the opposing distance between the lens and the substrate is decided by the connection (see, for example, Japanese Patent Application Laid-Open No. 2000-125212). In such an image pickup module, since the distance from the lens to the light receiving section placed in the image pickup element is automatically decided by just designing the shape of the lens holder based on the optical characteristics of the lens, the step of adjusting the focus distance of the lens is not required. In addition, there was proposed an image pickup module in which a lens holder holding a lens is bonded and fixed to a surface of a transparent plate attached to a substrate where the image pickup element is mounted (see, for example, Japanese Patent Application Laid-Open No. 2001-351997).

However, in the structure disclosed in Japanese Patent Application Laid-Open No. 2000-125212, since the surface of the substrate is used as a positioning reference, accuracy is required for mounting the image pickup element on the substrate, and positioning accuracy is also required for mounting the lens holder holding the lens on the substrate. Thus, this structure is not quite sufficient for the simplification of the mounting process and improvement in focus accuracy. Further, although the figure tolerance of the surface of the substrate as the positioning reference is important, in general, the surface of the substrate has irregularity, and therefore a smoothing process is necessary and causes a problem of cost increase.

In the structure disclosed in Japanese Patent Application Laid-Open No. 2001-351997, since the transparent plate and the lens holder are bonded together, a bonding stress acts on the transparent plate. This stress may cause a crack in the adhesive section that bonds the transparent plate and the image pickup element together, and may further cause a possibility of separation of the transparent plate from the image pickup element. In particular, this structure is insufficient for use in cell phones that require high impact resistance. Moreover, if there is a large difference in the thermal expansion coefficient between the transparent plate and the lens holder, the transparent plate may be curved during bonding due to the difference in the thermal expansion coefficient, and consequently displacement of the path of incident light and the problem of out of focus are caused by the influence.

### BRIEF SUMMARY OF THE INVENTION

The present invention has been made with the aim of solving the above problems, and it is an object of the present invention to provide an image pickup module that does not require an adjustment of an optical position because it can control the optical position of incident light to be focused on a light receiving section with a first fixing section and a second fixing section by fixing the first fixing section in the form of a tube to a surface of a base where an image pickup element including the light receiving section covered with a transparent body is placed and bringing the second fixing section in the form of a tube with a tube inner surface to which a lens is fixed into contact with a tube inner surface of the first fixing section and a surface of the transparent body, and is capable of improving the path accuracy of incident light with respect to the light receiving section and further improving the shock resistance against external forces, and provide a manufacturing method of the image pickup module.

It is a further object of the invention to provide an image pickup module capable of automatically controlling the optical position in a plane direction normal to the optical axis of incident light and reducing displacement of the position of incident light on the light receiving section by fixing the base and the first fixing section together based on the position of the light receiving section with respect to the base, and provide a manufacturing method of the image pickup module.

It is a further object of the invention to provide an image pickup module capable of certainly focusing incident light on the light receiving section by a structure in which the optical position in the optical axis direction of incident light is controlled by setting a position in the second fixing section where the lens is to be fixed.

It is a further object of the invention to provide an image pickup module including the image pickup element having a connecting section for connecting to a wiring provided on the base and capable of improving durability by covering the connecting section with the first fixing section to protect the connecting section from outside, for example, prevent decay (oxidation) of the connecting section due to an inflow of moisture from outside.

It is a further object of the present invention to provide an image pickup module that does not require an adjustment of an optical position because it can control the optical position of incident light to be focused on a light receiving section by the shape of a fixing section by fixing the light receiving section to a surface of a base where an image pickup element covered with a transparent body is placed and bringing the fixing section to which a lens is fixed into contact with a surface of the transparent body, and is capable of improving the path accuracy of incident light with respect to the light receiving section and further improving the shock resistance against external forces, and provide a manufacturing method of the image pickup module.

It is a further object of the invention to provide an image pickup module capable of automatically controlling the position of a contact section with respect to the transparent body and eliminating the necessity of adjustment of the optical position by a structure in which the contact section engages with the periphery of the transparent body

It is a further object of the invention to provide an image pickup module capable of automatically controlling the optical position in a plane direction normal to the optical axis of incident light and reducing displacement of the position of incident light on the light receiving section by fixing the base and the fixing section together based on the position of the light receiving section with respect to the base, and provide a manufacturing method of the image pickup module.

It is a further object of the invention to provide an image pickup module capable of certainly focusing incident light on the light receiving section by a structure in which the optical position in the optical axis direction of incident light is controlled by setting a position in the fixing section where the lens is to be fixed.

It is a further object of the invention to provide an image pickup module including the image pickup element having a connecting section for connecting to a wiring provided on the base and capable of improving durability by covering the connecting section with the fixing section to protect the connecting section from outside, for example, prevent decay (oxidation) of the connecting section due to an inflow of moisture from outside.

It is a further object of the invention to provide an image pickup module capable of blocking infrared rays from outside, for example, in addition to protecting the surface of the light receiving section from dust, scratches, etc. with the transparent body, by providing a wavelength selecting filter for selecting a wavelength to be passed on the transparent body, and suitable for various kinds of optical devices such as cameras and video recorder cameras.

It is a further object of the invention to provide an image pickup module capable preventing a physical stress from being applied to the light receiving section and preventing a decrease in the light-transmitting property between the light receiving section and the transparent body by a structure in which the image pickup element and the transparent body are bonded together while maintaining a predetermined gap therebetween through an adhesive section positioned outside the light receiving section.

An image pickup module according to the present invention is an image pickup module comprising: an image pickup element placed on a surface of a base and including a light receiving section covered with a transparent body; a lens for guiding incident light to the light receiving section; and a fixing section, fixed to the base, for controlling a position of the lens with respect to the light receiving section, and characterized in that the fixing section includes a first fixing section in a tube form fixed to the surface of the base, and a second fixing section in a tube form in contact with an internal tube surface of the first fixing section and a surface of the transparent body, and the lens is fixed to an internal tube surface of the second fixing section.

The image pickup module according to the present invention is characterized in that an optical position in a plane direction normal to an optical axis of the incident light is controlled by setting a position of the first fixing section with respect to the base.

The image pickup module according to the present invention is characterized in that an optical position in an optical axis direction of the incident light is controlled by setting a position in the second fixing section where the lens is to be fixed.

The image pickup module according to the present invention is characterized in that the base has a wiring, the image pickup element has a connecting section for connecting to the wiring, and the connecting section is covered with the first fixing section.

An image pickup module according to the present invention is an image pickup module comprising: an image pickup element placed on a surface of a base and including a light receiving section covered with a transparent body; a lens for guiding incident light to the light receiving section; and a fixing section, fixed to the base, for controlling a position of the lens with respect to the light receiving section, characterized in that the fixing section includes a contact section that comes into contact with a surface of the transparent body.

The image pickup module according to the present invention is characterized in that the contact section engages with a periphery of the transparent body

The image pickup module according to the present invention is characterized in that an optical position in a plane direction normal to an optical axis of the incident light is controlled by setting a position of the fixing section with respect to the base.

The image pickup module according to the present invention is characterized in that an optical position in an optical axis direction of the incident light is controlled by setting a position in the fixing section where the lens is to be fixed.

The image pickup module according to the present invention is characterized in that the base has a wiring, the image pickup element has a connecting section for connecting to the wiring, and the connecting section is covered with the fixing section.

The image pickup module according to the present invention is characterized in that the transparent body has a wavelength selecting filter for selecting a wavelength to be passed.

The image pickup module according to the present invention is characterized in that the image pickup element and the transparent body are bonded together while maintaining a predetermined gap therebetween through an adhesive section positioned outside the light receiving section.

A manufacturing method of an image pickup module according to the present invention is a manufacturing method of an image pickup module comprising an image pickup element placed on a surface of a base and including a light receiving section covered with a transparent body, a lens for guiding incident light to the light receiving section, a first fixing section in a tube form fixed to the base; and a second fixing section in a tube form for holding the lens, and characterized by comprising: a first fixing step of fixing the base and the first fixing section together; and a second fixing step of fixing the second fixing section and the first fixing section together in contact with an internal tube surface of the first fixing section and a surface of the transparent body

The manufacturing method of an image pickup module according to the present invention is characterized in that the first fixing step controls an optical position in a plane direction normal to an optical axis of the incident light by fixing the base and the first fixing section together based on a position of the light receiving section with respect to the base.

The manufacturing method of an image pickup module according to the present invention is characterized in that the second fixing step further fixes the second fixing section and the transparent body together.

A manufacturing method of an image pickup module according to the present invention is a manufacturing method of an image pickup module comprising an image pickup element placed on a surface of a base and including a light receiving section covered with a transparent body; a lens for guiding incident light to the light receiving section; and a fixing section in a tube form fixed to the base, holding the lens and having a contact section that comes into contact with a surface of the transparent body, and
characterized by comprising a fixing step of fixing the base and the fixing section together in a state in which the contact section is in contact with the surface of the base.

The manufacturing method an image pickup module according to the present invention is characterized in that the fixing step controls an optical position in a plane direction normal to an optical axis of the incident light by fixing the base and the fixing section together based on a position of the light receiving section with respect to the base.

The manufacturing method of an image pickup module according to the present invention is characterized in that the fixing step further fixes the contact section and the transparent body together.

In this invention, by fixing the first fixing section in a tube form to the surface of the base where the image pickup element including the light receiving section covered with the transparent body is placed and bringing the second fixing section in a tube form with an internal tube surface to which the lens is fixed into contact with both the internal tube surface of the first fixing section and the surface of the transparent body, the base surface direction of the lens mounted in the second fixing section, that is, the optical position in a plane direction normal to the optical axis of incident light, and the optical position in an optical axis direction of incident light to be focused on the light receiving section are controlled by the first fixing section and the second fixing section by using the transparent body as a positioning reference. Consequently, an adjustment of the optical position is not required, and it is possible to improve the path accuracy of incident light with respect to the light receiving section and further improve the shock resistance against external forces.

In this invention, since the optical position in a plane direction normal to the optical axis of incident light is automatically controlled by fixing the base and the first fixing section together based on the position of the light receiving section with respect to the base so that the center of the lens mounted in the second fixing section is aligned with the optical center of the light receiving section, it is possible to reduce displacement of the position of incident light on the light receiving section. Consequently, the step of adjusting the position of the lens with respect to the light receiving section after mounting is not required, and it is possible to reduce the cost of manufacturing.

In this invention, since the second fixing section is in contact with the surface of the transparent body, if the position of the lens to be fixed in the second fixing section is designed (set) in advance, the optical position in the optical axis direction of incident light is automatically controlled by mounting the first fixing section and the second fixing section, and therefore it is possible to certainly focus incident light on the light receiving section. Consequently, the step of adjusting the opposing distance between the lens and the light receiving section after mounting is not required, and it is possible to reduce the cost of manufacturing.

In this invention, the image pickup element has a connecting section for connecting to the wiring provided on the base, and the connecting section is covered with the first fixing section, and therefore it is possible to prevent external moisture, dust, etc. from damaging the connecting section, and it is possible to improve durability. For example, if the connecting section is made from a metal, it is possible to prevent decay (oxidation) of the connecting section due to an inflow of moisture.

In this invention, by fixing the fixing section to which the lens is fixed to the surface of the base where the image pickup element including the light receiving section covered with the transparent body is placed and brining the fixing section (contact section) into contact with the surface of the transparent body, the base surface direction of the lens mounted in the fixing section, that is, the optical position in a plane direction normal to the optical axis of incident light, and the optical position in the optical axis direction of incident light to be focused on the light receiving section are controlled by the shape of the fixing section by using the transparent body as a positioning reference. Consequently, an adjustment of the optical position is not required, and it is possible to improve the path accuracy of incident light with respect to the light receiving section and further improve the shock resistance against external forces.

In this invention, since the contact section engages with the periphery of the transparent body, the position of the contact section with respect to the transparent body is automatically controlled, and it is not necessary to adjust the optical position.

In this invention, since the optical position in a plane direction normal to the optical axis of incident light is automatically controlled by fixing the base and the fixing section together based on the position of the light receiving section with respect to the base so that the center of the lens mounted in the fixing section is aligned with the optical center of the light receiving section, it is possible to reduce displacement of the position of incident light on the light receiving section. Consequently, the step of adjusting the position of the lens with respect to the light receiving section after mounting is not required, and it is possible to reduce the cost of manufacturing.

In this invention, since the contact section is in contact with the surface of the transparent body, if the position of the lens to be fixed in the fixing section is designed (set) in advance, the optical position in the optical axis direction of incident light is automatically controlled by mounting the fixing section, and therefore it is possible to certainly focus incident light on the light receiving section. Consequently, the step of adjusting the opposing distance between the lens and the light receiving section after mounting is not required, and it is possible to reduce the cost of manufacturing.

In this invention, the image pickup element has a connecting section for connecting to the wiring provided on the base, and the connecting section is covered with the fixing section, and therefore it is possible to prevent external moisture, dust, etc. from damaging the connecting section, and it is possible to improve durability. For example, if the connecting section is made from a metal, it is possible to prevent decay (oxidation) of the connecting section due to an inflow of moisture.

In this invention, by providing a wavelength selecting filter for selecting a wavelength to be passed on the transparent body, it is possible to block external infrared rays, for example, in addition to protect the surface of the light receiving section from dust, scratches, etc. with the transparent body, and it is possible to provide an optical characteristic (image pickup module) suitable for various kinds of optical devices such as cameras and video recorder cameras.

In this invention, since the image pickup element and the transparent body are bonded together while maintaining a predetermined gap therebetween through the adhesive section positioned outside the light receiving section, a physical stress is not applied to the light receiving section, and it is possible to prevent a decrease in the light-transmitting property between the light receiving section and the transparent body.

In this invention, by further fixing the second fixing section and the transparent body together, the positional relationship between the second fixing section and the transparent body does not vary, the possibility of displacement of the position of the lens mounted in the second fixing section with respect to the transparent body is reduced, and the optical position of incident light can be more firmly controlled.

In this invention, by further fixing the contact section and the transparent body together, the positional relationship between the fixing section and the transparent body does not vary, thereby producing advantageous effects, such as reducing the possibility of displacement of the position of the lens mounted in the fixing section with respect to the transparent body, and more firmly controlling the optical position of incident light.

The above and further objects and features of the invention will more fully be apparent from the following detailed description with accompanying drawings.

### BRIEF DESCRIPTION OF THE SEVERAL VIEWS OF THE DRAWINGS

FIG. 1 is a sectional side view showing the structure of an image pickup module according to Embodiment 1 of the present invention;
FIG. 2 is a plan view of the image pickup module of Embodiment 1 of the present invention seen from a light incident side;
FIGS. 3A and 3B are explanatory views showing a manufacturing method of an image pickup module according to Embodiment 1 of the present invention;
FIGS.4A to 4E are explanatory views showing a manufacturing method of an image pickup module according to Embodiment 1 of the present invention;
FIGS. 5A to 5C are explanatory views showing a manufacturing method of an image pickup module according to Embodiment 1 of the present invention;
FIGS. 6A and 6B are explanatory views showing a manufacturing method of an image pickup module according to Embodiment 1 of the present invention;
FIG. 7 is a sectional side view showing the structure of an image pickup module according to Embodiment 2 of the present invention; and
FIGS. 8A to 8C are explanatory views showing a manufacturing method of an image pickup module according to Embodiment 2 of the present invention.

### DETAILED DESCRIPTION OF THE INVENTION

The following description will explain in detail the present invention, based on the drawings illustrating some embodiments thereof.

### (Embodiment 1)

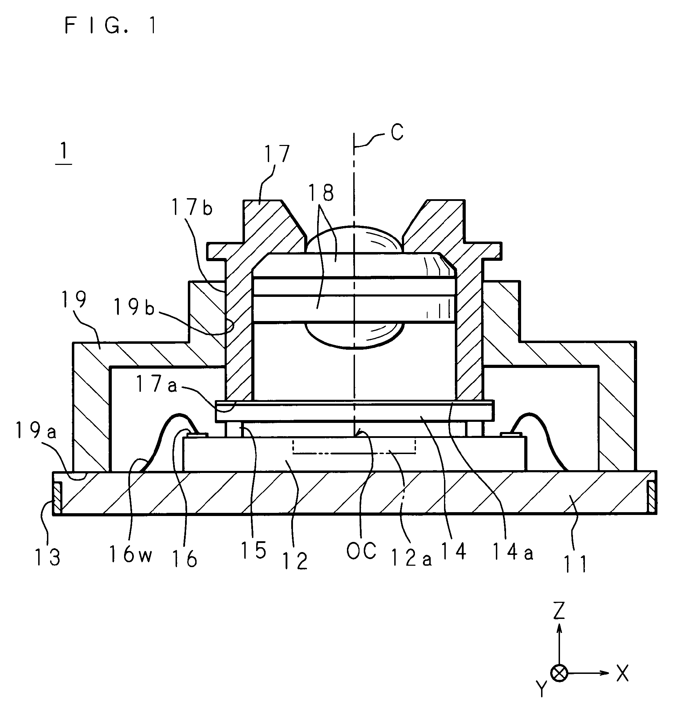

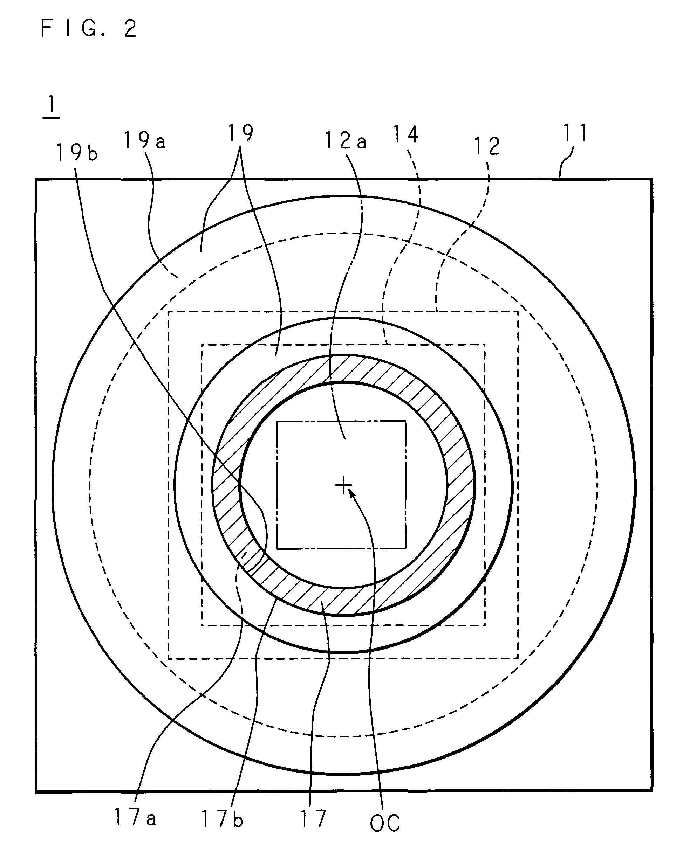

FIG. 1 is a sectional side view showing the structure of an image pickup module according to Embodiment 1 of the present invention, and FIG. 2 is a plan view of the image pickup module of Embodiment 1 of the present invention seen from a light incident side. Note that illustration of part of the components is omitted in FIG. 2 to facilitate understanding of the positional relationship among an image pickup element, a lens holder and a cover, which is a characteristic of the present invention.

In an image pickup module 1 of Embodiment 1 of the present invention, an image pickup element 12 is bonded to one surface of a substrate (base) 11 by dice bonding. The image pickup element 12 is one type of semiconductor element, such as a CCD or a CMOS imager, and comprises a light receiving section 12a in the center of a chip, and peripheral circuits, such as a read circuit for reading a signal based on the light quantity detected by the light receiving section 12a, on the periphery of the chip. Such an image pickup element 12 is manufactured by stacking a plurality of layers on a semiconductor wafer by using known semiconductor manufacturing techniques. The condensing percentage on the light receiving section 12a may be increased by forming a micro lens on the upper surface of the light receiving section 12a.

In the image pickup element 12, a transparent plate (transparent body) 14 made from a material such as a light-transmitting glass or a light-transmitting resin and processed accurately in terms of plate thickness and figure tolerance of the surface is fixed on the surface of the image pickup element 12 through an adhesive section 15 while maintaining a predetermined gap (about 2 µm error) from the surface of the image pickup element 12. By covering at least the light receiving section 12a with the transparent plate 14, it is possible to protect (the surface of) the light receiving section 12a from external moisture, dust (refuse, chips), etc. It may of course be possible to cover the peripheral circuits with the transparent plate 14 in addition to the light receiving section 12a. If the image pickup element 12 is connected to the substrate 11 through a bonding pad (connecting section) 16 provided on the chip periphery of the image pickup element 12, the inner area with respect to the bonding pad 16 needs to be covered with the transparent plate 14. Note that a conductor passing through the semiconductor chip as the image pickup element 12 may be provided on the opposite surface in place of the bonding pad 16, and the conductor may be directly bonded to a wiring formed on the surface of the substrate 11.

An image pickup module for optical devices such as cameras and video recorder cameras is required not only to protect the surface of the light receiving section 12a from dust, scratches, etc., but also to block external infrared rays. In this case, an infrared-ray blocking filter 14a is attached to a surface of the transparent plate 14 opposite to a surface facing the image pickup element 12, namely the incident-side surface. The infrared-ray blocking filter 14a is composed, for example, of a dielectric multi-layer film constructed by stacking a high refractive layer made from titanium oxide, zirconium oxide, zinc sulfide, etc. and a low refractive layer made from magnesium fluoride, calcium fluoride, silicon dioxide, etc. alternately in many layers, and can selectively block infrared rays by using the interference of light. Of course, the filter is not limited to the infrared-ray blocking filter, and a wavelength selecting filter capable of selecting a wavelength to be passed may be suitably provided according to the application.

The adhesive section 15 is formed with a thickness error of no larger than about 2 µm to enclose the periphery of the transparent plate 14. Although it is possible to bond the image pickup element 12 and the transparent plate 14 together through the adhesive section 15 so that the gap therebetween is completely sealed, it is just necessary to reduce the occurrence of defects in the light receiving section 12a due to the entry of moisture, entry and adhesion of dust, scratches, etc into the light receiving section 12a. Also, in order to prevent dew condensation, it may be possible to form a minute cut or a maze-like vent path (air path) for discharging moisture entered the inside to outside and ventilate the space created by the image pickup element 12 and the transparent plate 14.

The substrate 11 is a multi-layer wiring substrate, for example, and has a predetermined wiring (not shown) on a surface thereof, and the wiring and the bonding pad 16 provided on the chip periphery of the image pickup element 12 are connected with a bonding wire 16w. Thus, the chip periphery of the image pickup element 12 is an exposed area that is not covered with the transparent plate 14, and allows easy wire bonding. Semiconductor devices (not shown), such as a DSP for supplying a control signal to the image pickup element 12 or processing an output signal from the image pickup element 12, are suitably mounted on the image pickup element mount surface of the substrate 11, or the opposite surface. These semiconductor devices are connected to an external circuit outside the module through a terminal 13 provided in a side face (or rear face) of the substrate 11.

The image pickup element 12 captures light incident from outside into the inside thereof through the transparent plate 14, and receives the light (detects the light) by the light receiving section 12a. The light received in the light receiving section 12a is converted into a predetermined electric signal by the image pickup element 12, and the electric signal is fetched from the bonding pad through the bonding wire 16w.

The image pickup module 1 comprises a cover (a fixing section, a first fixing section) 19 in the form of a tube, and a lens holder (a fixing section, a second fixing section) 17. The cover 19 is fixed (bonded) to the substrate 11 in a state in which its leg section 19a is in contact with the surface of the substrate 11. Further, the lens holder 17 is inserted into the inner surface 19b of the cover 19, and the outer surface 17b of the lens holder 17 is fixed (bonded) to the inner surface 19b of the cover 19 in a state in which the leg section 17a of the lens holder 17 is in contact with the transparent plate 14 and the outer surface 17b is in contact with the inner surface 19b of the cover 19. Lenses 18 for guiding the path of incident light to the light receiving section 12a of the image pickup element 12 are fixed to a predetermined position of the lens holder 17. Although this embodiment illustrates the case where two lenses 18 are used, one lens 18 or a plurality of lenses 18 may be used in combination according to a need.

Since the lens 18 decides the optical path of incident light, the position thereof has a great influence on the reception of an image by the light receiving element 12. In this embodiment, the optical position in a plane direction normal to the optical axis of incident light is controlled by setting a position on the surface of the substrate 11 where the leg section 19a of the cover 19 is to be bonded. In other words, since the outer surface 17b of the lens holder 17 is in contact with the inner surface 19b of the cover 19, the substrate surface direction of the lens 18 mounted in the lens holder 17, or the XY direction of the light receiving section 12a, is controlled. Therefore, if the shapes of the cover 19 and lens holder 17 are designed in advance so that the center C of the lens 18 mounted in the lens holder 17 is aligned with the optical center OC of the light receiving section 12a, the optical position of the lens 18 in the XY direction with respect to the light receiving section 12a is automatically decided by mounting the cover 19 and the lens holder 17, and the step of adjusting the position becomes unnecessary.

Moreover, since the lens holder 17 is fixed in a state in which the leg section 17a of the lens holder 17 is in contact with the surface of the transparent plate 14, the opposing distance between the lens 18 and transparent plate 14 is decided by setting a position of mounting the lens 18 with respect to the leg section 17a, and the optical position in the optical axis direction of incident light (Z direction) is controlled. In other words, since the lens holder 17 is mounted in a state in which the leg section 17a is in contact with the surface of the transparent plate 14, the optical axis direction of the lens 18 mounted in the lens holder 17, that is, the Z direction of the light receiving section 12a, is controlled. Therefore, if a position of mounting the lens 18 is designed in advance so that the focal point of the lens 18 is focused on the light receiving section 12a, the optical position of the lens 18 in the Z direction with respect to the light receiving section 12a is automatically decided by mounting the cover 19 and the lens holder 17, and the step of adjusting the position becomes unnecessary.

As described above, the cover 19 and the lens holder 17 work in cooperation by the insertion of the lens holder 17 into the cover 19 and the contact with the transparent plate 14, and the optical position of the lens 18 in the XY direction and the Z direction with respect to the light receiving section 12 is decided using the surface of the transparent plate 14 as a positioning reference.

Moreover, since the inner surface 19b of the cover 19 is in contact with the lens holder 17, the cover 19 performs the above-mentioned optical position adjusting function. Also, since the leg section 19a is bonded to the substrate 11, the sealed space is created by the cover 19 and the substrate 11, and the cover 19 performs the function of protecting the image pickup element 12 from external environments. Further, since the transparent plate 14 and the lens holder 17 are not bonded together, it is possible to prevent a bonding stress from acting on the transparent plate 14 as in a prior art, and there is absolutely no possibility of separation of the transparent plate 14 from the image pickup element 12. Hence, this structure is suitable for cell phones that require high impact resistance. Of course, the transparent plate 14 will not be warped, and the path of incident light will not be displaced. It may of course be possible to bond the leg section 17a of the lens holder 17 to the surface of the transparent plate 14 to a degree in which bonding stress does not have influence.

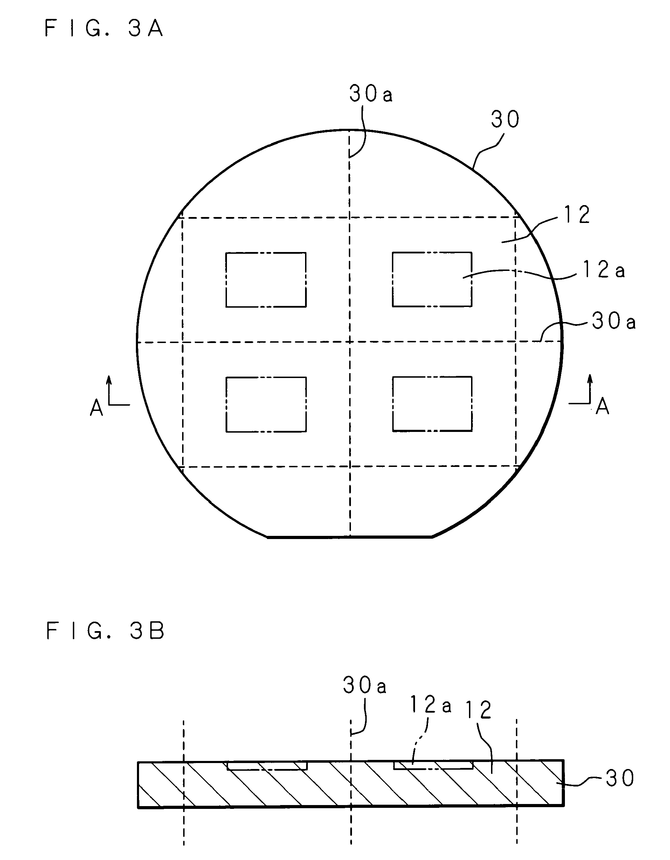

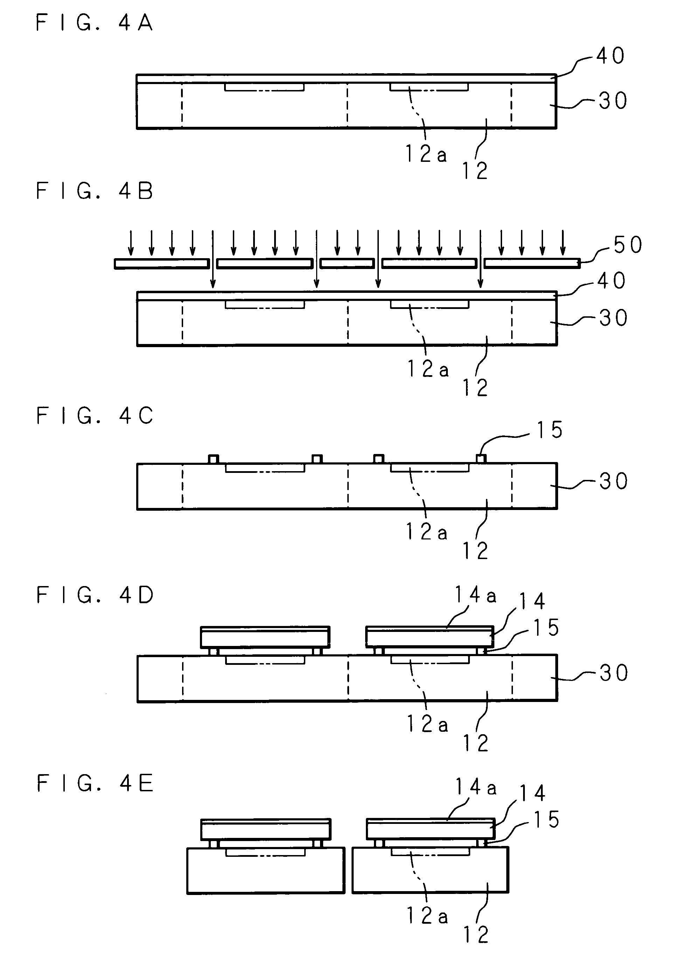

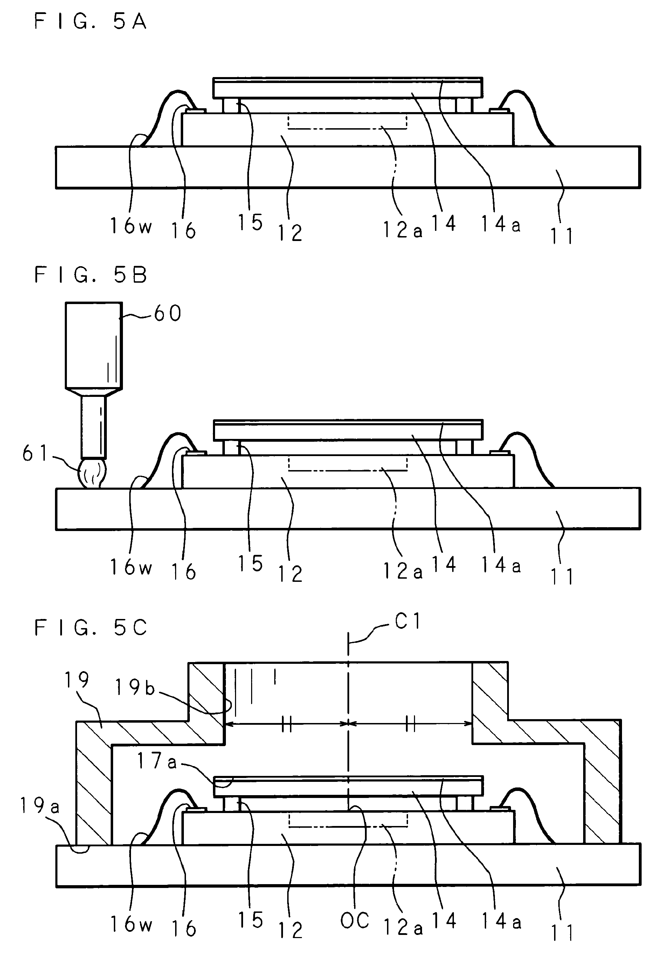

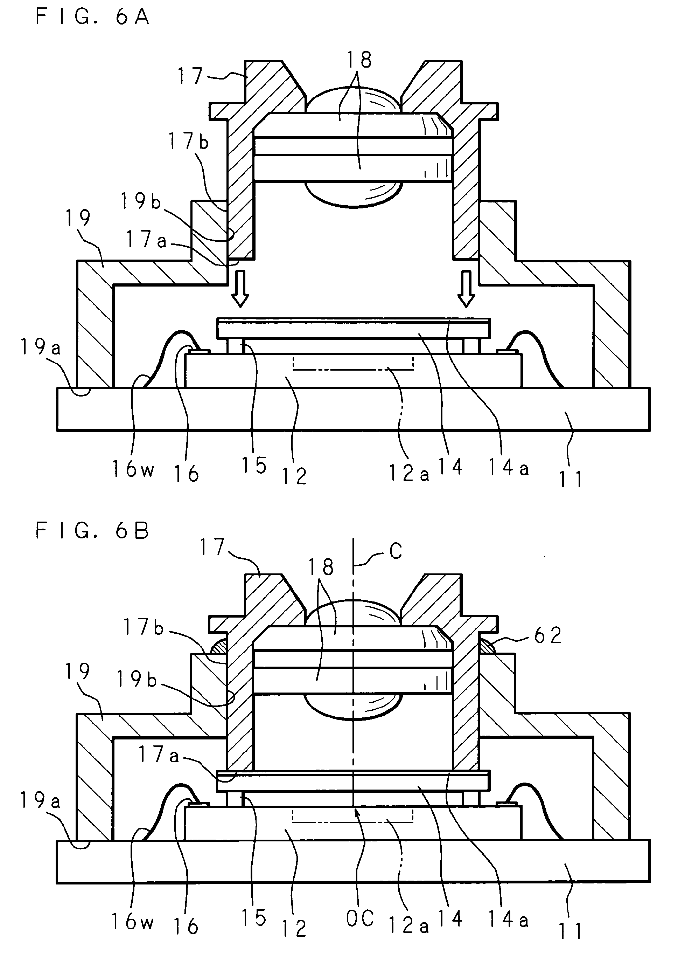

Next, the following description will explain a manufacturing method of the above-mentioned image pickup module 1. FIGS. 3A, 3B, 4A to 4E, 5A to 5C, 6A and 6B are explanatory views showing a manufacturing method of an image pickup module according to Embodiment 1 of the present invention. More specifically, FIGS. 3A and 3B show the state of the image pickup elements formed on a semiconductor wafer, FIGS. 4A to 4E show the process of bonding the image pickup element and the transparent plate, FIGS. 5A to 5C show the process of fixing the cover to the substrate on which the image pickup element is mounted, and FIGS. 6A and 6B show the process of fixing the lens holder to the cover.

FIG. 3A shows a state in which a plurality of image pickup elements 12 are formed on a semiconductor wafer 30. The image pickup elements 12 have the light receiving sections 12a, and are segmented by parting lines 30a. FIG. 3B is a structural sectional view along the A-A line of FIG. 3A.

First, an adhesive layer 40 in the form of liquid or film is applied or attached to one surface (plane having the light receiving section 12a) of a plurality of image pickup elements 12 formed on a semiconductor wafer 30 (FIG. 4A). The adhesive layer 40 is obtained by suitably mixing a photosensitive adhesive that is cured by exposure to light with a thermosetting adhesive that has an adhesive strength by application of heat. An example of the photosensitive adhesive is an ultraviolet (UV) curing resin as an acryl based resin, and an example of the thermosetting resin is an epoxy based resin.

Next, the adhesive layer 40 is exposed to UV light through a photo mask 50 (FIG. 4B). The photo mask is patterned so that an outer area in an area corresponding to the light receiving section 12a of the image pickup element 12 is exposed to light. When the photosensitive adhesive contained in the adhesive layer 40 is exposed (sensitized) to UV light, it causes a photo polymerization reaction and is changed into a substance that is not dissolved in a predetermined developer. Then, by developing the adhesive layer 40 with a predetermined developer, the adhesive layer in an area which has not been sensitized to UV light is removed, and a predetermined pattern is formed (FIG. 4C). In other words, by using a photolithography technique, a shape enclosing the light receiving section 12a of the image pickup element 12, namely the adhesive section 15 in the form of a frame, is formed simultaneously for all of the plurality of image pickup elements 12 formed in the semiconductor wafer 30. Since the adhesive sections 15 are formed for the respective image pickup elements 12 at the same time, it is possible to improve productivity

Further, by placing the transparent plate 14 such as a glass with one surface to which an infrared-ray blocking filter 14a is attached in advance and separated into individual pieces on the adhesive section 15 and heating them while maintaining this state, adhesiveness appears in the thermosetting adhesive contained in the adhesive section 15, and the adhesive section 15 and the transparent plate 14 are bonded together (FIG. 4D). Since the adhesive section 15 and the image pickup element 12 are not sufficiently bonded with only the adhesive strength appeared in the photosensitive adhesive in the exposure step, the adhesiveness between the adhesive section 15 and the image pickup element 12 is improved by this heating process. Of course, the adhesiveness may be caused by placing them in a high-temperature vessel with a predetermined temperature, or by applying pressure during heating. Consequently, a space is formed by the image pickup element 12, the transparent plate 14 and the adhesive section 15, and it is possible to reduce the occurrence of defects in the light receiving section due to the entry of moisture, entry and adhesion of dust, scratches, etc. into the light receiving section 12a in the subsequent steps.

Next, the semiconductor wafer 30 is cut and divided into individual image pickup elements 12 by a dicing device such as a dicing saw (FIG. 4E). In this dividing step, the rear surface of the semiconductor wafer 30 with the transparent plate 14 bonded through the adhesive section 15 is put on a dicing tape fixed to a dicing ring, and the semiconductor wafer 30 is divided into individual image pickup elements 12 by moving the dicing saw in a dicing direction. Then, by separating the divided image pickup elements 12 from the dicing tape under a suitable condition, individual elements can be obtained.

By using the above-mentioned photolithography technique, it is possible to form the adhesive sections 15 in the form of a frame on a plurality of image pickup elements 12 by a single processing flow, and the positioning accuracy of the formed adhesive section 15 with respect to the substrate 11 is extremely high because positioning of the photo mask 50 is performed using an alignment mark provided on the substrate 11. Therefore, the image pickup element 12 to which the transparent plate 14 is bonded through the adhesive section 15 can use the surface of the transparent plate 14 as a reference surface having an extremely high accuracy with respect to the light receiving section 12a. Note that it may be possible to form an adhesive section on the transparent plate and bond the image pickup element through the adhesive section, or it may be possible to bond a transparent plate in the form of a single plate (one piece of plate) with a size covering a plurality of image pickup elements to a semiconductor wafer in which a plurality of image pickup elements are formed, and then cut and divide the semiconductor wafer and the transparent plate into individual image pickup elements by using a dicing device. In this case, if the bonding pad formed in each image pickup element is hidden by the transparent plate during wire bonding for connecting the bonding pad to an external circuit, it is necessary to suitably modify the bonding device, and therefore it is preferable to suitably cut the semiconductor wafer and the transparent plate in the diving step so that the plane dimensions of the cut transparent plate are smaller than the plane dimensions of the cut semiconductor wafer (image pickup element).

FIG. 5A shows a state in which the image pickup element 12 covered with the transparent substrate 14 thus obtained is directly bonded to the substrate 11, and the bonding pad 16 provided on the chip periphery of the image pickup element 12 and the wiring provided on the surface of the substrate 11 are connected with the bonding wire 16w. First, a dispenser 60 is filled with an adhesive 61, and the filled adhesive 61 is dispensed on a predetermined area of the substrate surface (here, the circumference around the substrate) while moving the dispenser 60 (FIG. 5B). Then, a position on the substrate surface where the cover 19 is to be placed is found by recognizing the pattern of wiring provided on the substrate surface, the cover 19 is placed on the found position, and the cover 19 and the substrate 11 are bonded with the adhesive 61 (FIG. 5C). It is thus possible to bond the cover 19 to the substrate 11 so that its center Cl becomes the center of imaging of the image pickup element 12, that is, the optical center OC of the light receiving section 12a.

Next, the lens holder 17 with the lens 18 fixed to a predetermined position is inserted along the inner surface 19b of the cover 19 (FIG. 6A), and the leg section 17a of the lens holder 17 is brought into contact with the transparent plate 14. The inner surface shape of the cover 19 and the outer surface shape of the lens holder 17 are molded to be substantially the same beforehand, and the outer surface 17b of the lens holder 17 is in contact with the inner surface 19b of the cover 19. In this state, an edge of the cover 19 and the lens holder 17 are bonded with an adhesive 62 (FIG. 6B). Since the lens holder 17 is fixed in contact with the inner surface 19b of the cover 19, the XY direction of the lens holder 17 is controlled by the position of the cover 19, and the center C of the lens 18 fixed to the lens holder 17 is aligned with the optical center OC of the light receiving section 12a. Moreover, since the leg section 17a of the lens holder 17 is fixed in contact with the surface of the transparent plate 14, the opposing distance between the lens 18 fixed to the lens holder 17 and the transparent plate 14 does not vary, and the optical position in the optical axis direction of incident light (Z direction) is controlled.

Although this embodiment illustrates, as a mode of fixing the lens holder 17 and the cover 19, a mode in which an edge of the cover 19 and an edge of the lens holder 17 are bonded with the adhesive 62, it may be possible to bond the inner surface 19b of the cover 19 and the outer surface 17b of the lens holder 17 with an adhesive. In the case where the infrared-ray blocking filter 14a is attached to the surface of the transparent plate 14, it is preferable to use an adhesive having a sufficient adhesiveness with respect to the infrared-ray blocking filter 14a. It may of course be possible to suitably process the shape of the infrared-ray blocking filter 14a and attach the infrared-ray blocking filter 14a to the transparent plate 14 so that the leg section 17a of the lens holder 17 and the transparent plate 14 come into direct contact with each other.

### (Embodiment 2)

Although Embodiment 1 illustrates a mode in which the optical position of the lens in the XY direction and the Z direction is respectively controlled by the cover and the lens holder, it may be possible to use a lens holder that functions as a cover.

### Embodiment 2 illustrates an example using such a lens holder.

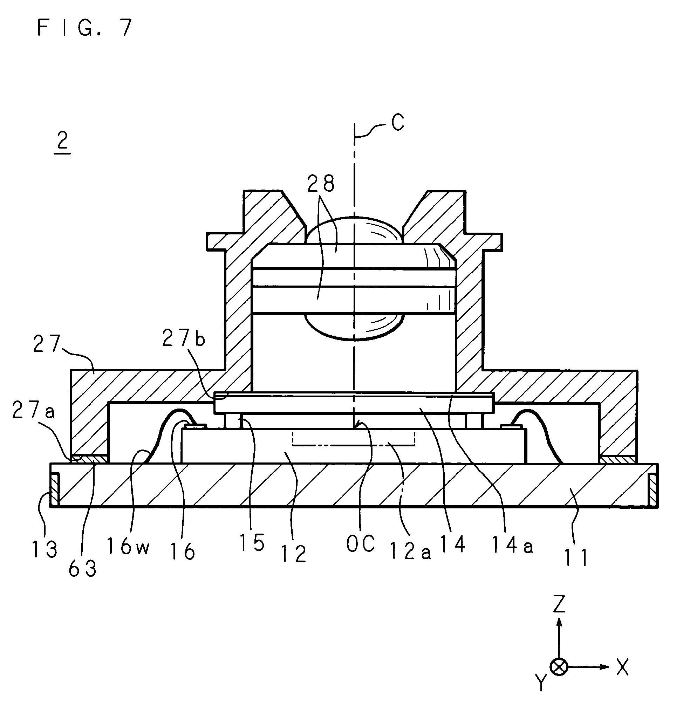

FIG. 7 is a sectional side view showing the structure of an image pickup module according to Embodiment 2 of the present invention.

An image pickup module 2 of Embodiment 2 of the present invention comprises a lens holder (fixing section) 27 functioning as a cover explained in Embodiment 1. A lens 28 for guiding the path of incident light to the light receiving section 12a of the image pickup element 12 is fixed on a predetermined position of the lens holder 27. The lens holder 27 has a step section 27b functioning as a contact section of the present invention, and a leg section 27a fixed (bonded) to the surface of the substrate 11 with an adhesive 63 in a state in which the step section 27b engages with the periphery of the transparent plate 14 and in contact with the transparent plate 14. Since other structures are the same as in Embodiment 1, the corresponding sections are designated with the same codes, and the detailed explanation thereof will be omitted.

Since the lens 28 decides the optical path of incident light, the position thereof has a great influence on the reception of an image by the light receiving element 12. In this embodiment, by engaging the leg section 27a of the lens holder 27 with the periphery of the transparent plate 14, the position of the leg section 27a with respect to the transparent plate 14 is automatically controlled, and the optical position in a plane direction normal to the optical axis of incident light is controlled. In other words, the lens holder 27 controls the substrate surface direction of the lens 28 mounted in the lens holder 27, that is, the XY direction of the light receiving section 12a. Moreover, since the lens holder 27 is fixed in a state in which the step section 27b of the lens holder 27 is in contact with the surface of the transparent plate 14, the opposing distance between the lens 28 and the transparent plate 14 is decided by setting a position of mounting the lens 28 with respect to the step section 27b, and the optical opposition in the optical axis direction of incident light (Z direction) is controlled. In short, since the step section 27b of the lens holder 27 is in contact with the surface of the transparent plate 14, the optical axis direction of the lens 28 mounted in the lens holder 27, that is, the Z direction of the light receiving section 12a, is controlled.

Therefore, if the shape of the lens holder 27 and the position of mounting the lens 28 are designed in advance so that the center C of the lens 28 mounted in the lens holder 27 is aligned with the optical center OC of the light receiving section 12a, and that the focal point of the lens 28 is focused on the light receiving section 12a, the optical position of the lens 28 in the XY direction and the Z direction with respect to the light receiving section 12a is automatically decided by mounting the lens holder 27, and the step of adjusting the position becomes unnecessary.

Moreover, the lens holder 27 performs the above-described function of adjusting the optical position, and also performs the function of creating a sealed space by the lens holder 27 and the substrate 11 and protecting the image pickup element 12 from external environments by bonding the leg section 27a to the substrate 11. Thus, since the lens holder 27 performs the image pickup element protecting function as the cover 19 of Embodiment 1, it is possible to surely protect the image pickup element without increasing the number of components. Further, since the transparent plate 14 and the lens holder 27 are not bonded together, it is possible to prevent a bonding stress from acting on the transparent plate 14 as in a prior art, and there is absolutely no possibility of separation of the transparent plate 14 from the image pickup element 12. Hence, this structure is suitable for cell phones that require high impact resistance. Note that it is not necessarily required to engage the step section 27b with the periphery of the transparent plate 14, and the optical position in a plane direction normal to the optical axis of incident light may be controlled by setting a position on the surface of the substrate 11 where the leg section 27a of the lens holder 27 is to be bonded.

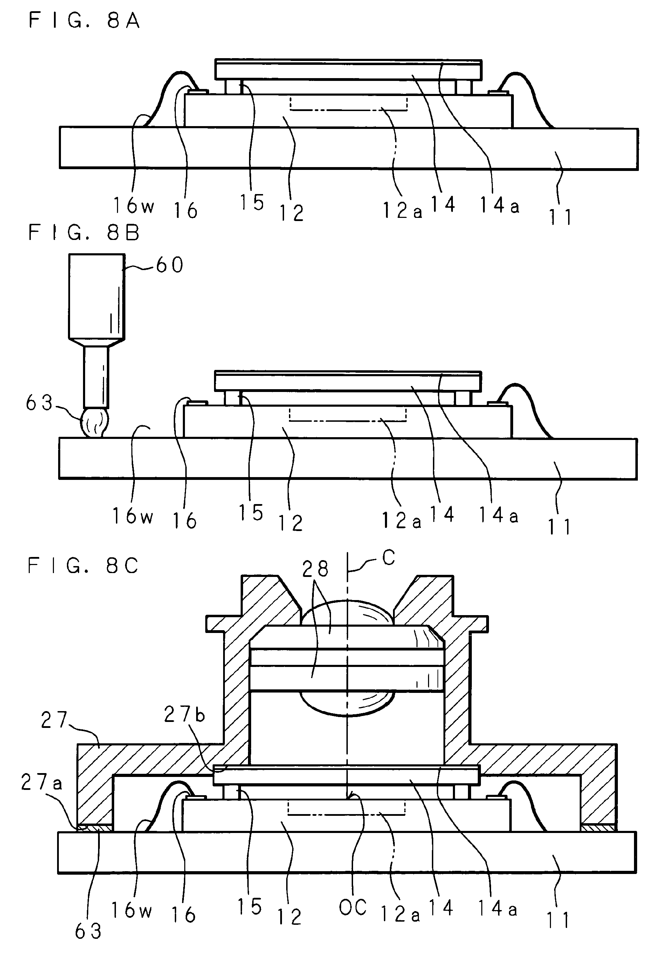

Next, the following description will explain a manufacturing method of the above-mentioned image pickup module 2. FIGS. 8A to 8C are explanatory views showing a manufacturing method of an image pickup module according to Embodiment 2 of the present invention, and more specifically illustrates the process of fixing a lens holder to a substrate where an image pickup element is mounted. Since the process of bonding the image pickup element and the transparent plate is the same as in Embodiment 1, the explanation thereof will be omitted.

FIG. 8A shows a state in which the image pickup element 12 covered with the transparent plate 14 is directly bonded to the substrate 11, and the bonding pad 16 provided on the chip periphery of the image pickup element 12 and the wiring provided on the surface of the substrate 11 are connected with the bonding wire 16w. First, a dispenser 60 is filled with an adhesive 63, and the filled adhesive 63 is dispensed on a predetermined area of the substrate surface (here, the circumference around the substrate) while moving the dispenser 60 (FIG. 8B). Then, a position on the substrate surface where the lens holder 27 is to be placed is found by recognizing the pattern of wiring provided on the substrate surface, the lens holder 27 is placed on the found position, and the lens holder 27 and the substrate 11 are bonded with the adhesive 63 (FIG. 8C). During bonding, the step section 27b of the lens holder 27 comes into contact with the transparent plate 14, and a gap is created between the leg section 27a of the lens holder 27 and the substrate 11, but this gap is filled with the adhesive 63.

The XY direction of the lens 28 fixed to the lens holder 27 with respect to the image pickup element is controlled by the position on the substrate 11 where the leg section 27a of the lens holder 27 is fixed, and the center C of the lens 28 is aligned with the center of imaging of the image pickup element 12, that is, the optical center OC of the light receiving section 12a. Moreover, since the step section 27b of the lens holder 27 is fixed in contact with the surface of the transparent plate 14, the opposing distance between the lens 28 fixed to the lens holder 27 and the transparent plate 14 does not vary, and the optical position in the optical axis direction of incident light (Z direction) is controlled.

Note that although this embodiment illustrates a mode in which the lens holder 27 and the transparent plate 14 are in contact with each other but are not bonded together, the step section 27b of the lens holder 27 and the transparent plate 14 may be bonded with an adhesive to a degree in which bonding stress does not have influence. In the case where the infrared-ray blocking filter 14a is attached to the surface of the transparent plate 14, it is preferable to use an adhesive having a sufficient adhesiveness with respect to the infrared-ray blocking filter 14a. Of course, it may be possible to suitably process the shape of the infrared-ray blocking filter 14a and attach the infrared-ray blocking filter 14a to the transparent plate 14 so that the leg section 27a of the lens holder 27 and the transparent plate 14 come into direct contact with each other.

Although the respective embodiments explain the case where the covering section is a transparent plate made of light-transmitting glass, the present invention is not restricted to this, and it may be possible to use a covering section made from a resin material, for example, or use a covering section that does have light-transmitting properties in some case.

## Claims

1. An image pickup module comprising: an image pickup element (12) placed on a surface of a base (11) and including a light receiving section (12a) covered with a transparent body (14); a lens (18) for guiding incident light to the light receiving section (12a); and a fixing section (17, 19), fixed to the base (11), for controlling a position of the lens (18) with respect to the light receiving section (12a), **characterized in that**
the fixing section (17, 19) includes a first fixing section (19) in a tube form fixed to the surface of the base (11), and a second fixing section (17) in a tube form in contact with an internal tube surface (19b) of the first fixing section (19) and a surface of the transparent body (14), and
the lens (18) is fixed to an internal tube surface of the second fixing section (17).

2. The image pickup module according to claim 1, wherein an optical position in a plane direction normal to an optical axis of the incident light is controlled by setting a position of the first fixing section (19) with respect to the base (11).

3. The image pickup module according to claim 1 or 2, wherein an optical position in an optical axis direction of the incident light is controlled by setting a position in the second fixing section (17) where the lens (18) is to be fixed.

4. The image pickup module according to any one of claims 1 to 3, wherein the base (11) has a wiring, the image pickup element (12) has a connecting section (16) for connecting to the wiring, and the connecting section (16) is covered with the first fixing section (19).

5. An image pickup module comprising: an image pickup element (12) placed on a surface of a base (11) and including a light receiving section (12a) covered with a transparent body (14); a lens (28) for guiding incident light to the light receiving section (12a); and a fixing section (27), fixed to the base (11), for controlling a position of the lens (28) with respect to the light receiving section (12a), **characterized in that**
the fixing section (27) includes a contact section (27b) that comes into contact with a surface of the transparent body (14).

6. The image pickup module according to claim 5, wherein the contact section (27b) engages with a periphery of the transparent body (14).

7. The image pickup module according to claim 5 or 6, wherein an optical position in a plane direction normal to an optical axis of the incident light is controlled by setting a position of the fixing section (27) with respect to the base (11).

8. The image pickup module according to any one of claims 5 to 7, wherein an optical position in an optical axis direction of the incident light is controlled by setting a position in the fixing section (27) where the lens (28) is to be fixed.

9. The image pickup module according to any one of claims 5 to 8, wherein the base (11) has a wiring, the image pickup element (12) has a connecting section (16) for connecting to the wiring, and the connecting section (16) is covered with the fixing section (27).

10. The image pickup module according to any one of claims 1 to 9, wherein the transparent body (14) has a wavelength selecting filter (14a) for selecting a wavelength to be passed.

11. The image pickup module according to any one of claims 1 to 10, wherein the image pickup element (12) and the transparent body (14) are bonded together while maintaining a predetermined gap therebetween through an adhesive section (15) positioned outside the light receiving section (12a).

12. A manufacturing method of an image pickup module comprising an image pickup element (12) placed on a surface of a base (11) and including a light receiving section (12a) covered with a transparent body (14), a lens (18) for guiding incident light to the light receiving section (12a), a first fixing section (19) in a tube form fixed to the base (11); and a second fixing section (17) in a tube form for holding the lens (18), **characterized by** comprising:
a first fixing step of fixing the base (11) and the first fixing section (19) together; and
a second fixing step of fixing the second fixing section (17) and the first fixing section (19) together in contact with an internal tube surface (19b) of the first fixing section (19) and a surface of the transparent body (14).

13. The manufacturing method of an image pickup module according to claim 12, wherein the first fixing step controls an optical position in a plane direction normal to an optical axis of the incident light by fixing the base (11) and the first fixing section (19) together based on a position of the light receiving section (12a) with respect to the base (11).

14. The manufacturing method of an image pickup module according to claim 12 or 13, wherein the second fixing step further fixes the second fixing section (17) and the transparent body (14) together.

15. A manufacturing method of an image pickup module comprising an image pickup element (12) placed on a surface of a base (11) and including a light receiving section (12a) covered with a transparent body (14), a lens (28) for guiding incident light to the light receiving section (12a), and a fixing section (27) in a tube form fixed to the base (11), holding the lens (28) and having a contact section (27b) that comes into contact with a surface of the transparent body (14), **characterized by** comprising
a fixing step of fixing the base (11) and the fixing section (27) together in a state in which the contact section (27b) is in contact with the surface of the base (11).

16. The manufacturing method of an image pickup module according to claim 15, wherein the fixing step controls an optical position in a plane direction normal to an optical axis of the incident light by fixing the base (11) and the fixing section (27) together based on a position of the light receiving section (12b) with respect to the base (11).

17. The manufacturing method of an image pickup module according to claim 15 or 16, wherein the fixing step further fixes the contact section (27b) and the transparent body (14) together.
